# EUROPEAN PATENT APPLICATION

(11) **EP 1 104 016 A1**
(43) Date of publication of application: **30.05.2001**
(21) Application number: 99309416.8
(22) Date of filing: 25.11.1999
(51) Int. Cl.: H01L 21/48

(54) **Lead assembly for semiconductor devices and assembling method therefor**

(71) Applicant: General Semiconductor of Taiwan, Ltd., Tsin Tien, Taiwan (TW)
(72) Inventor: Nelson, William John, c/o General Semiconductor, Hsin Tien, Taipei (TW); Lai, Stanley, c/o General Semiconductor, Hsin Tien, Taipei (TW); Lee, K.R., c/o General Semiconductor, Hsin Tien, Taipei (TW); Chen, Steve, c/o General Semiconductor, Hsin Tien, Taipei (TW)
(74) Representative: Barlow, Roy James

(57) **Abstract**

A lead assembly for semiconductor devices is disclosed. In the assembly of the present invention, the diameter and length of the leads are calculated according to product requirements. After cutting the leads into pieces of leads of a required diameter and length by automated machines, each of the leads is fixed on an joining band and these leads are separated from each other at a predetermined distance. For facilitating the automatic production, the joining band may be provided with some positioning holes for accurately transferring and positioning the assembly.

## Description

### BACKGROUND OF THE INVENTION

### 1. Field of the Invention

The invention relates to a lead assembly for semiconductor devices, and in particular, to a lead assembly in which each of the leads is fixed on a joining band and separated from each other by a predetermined distance.

### 2. Description of the Related Prior Art

A lead frame is utilized in a conventional lead assembly for semiconductor devices. The lead frame is made of a metal sheet such as a copper sheet, on which a chip pad is designed for placing the chip, a bonding pad is provided for connecting the lead to the chip, and the lead is finally soldered on a printed circuit board (or mounted on a socket). Although the above-mentioned conventional assembly can be produced by automatic machines, the ratio of the metal sheet utilized in the lead frame to the entire metal sheet is not high. Since a large part of unused metal sheet is discarded and only the remaining metal sheet is kept for utilization, the utilization ratio of the metal sheet is generally 20%-30%. Thus, utilization of the lead frame will waste resources and greatly increase fabrication costs.

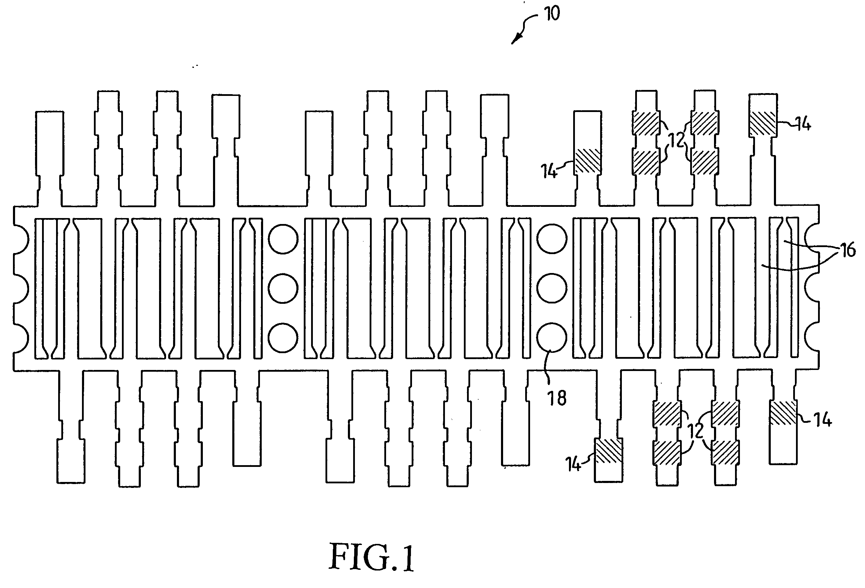

The lead frame 10 utilized in the conventional lead assembly for semiconductor devices is illustrated in Figure 1. The lead frame 10 is made of a piece of metal sheet. Chip pads 12 are provided on the metal sheet. Chips are disposed on the pads 12. Bonding pads 14 are used for connecting the leads to the chips. The leads finally are soldered on a printed circuit board. For utilizing the metal sheet efficiently, both the upper part and lower part of the lead frame 10 are provided with chip pads 12, bonding pads 14, and leads 16. For automated production, positioning holes 18 are separated from each other at a distance to facilitate positioning and separation. Although the lead frame shown in Figure 1 is suitable for automated production, the utilization ratio of the metal sheet is very low. Since the unused part of the metal sheet is discarded, resources are wasted and fabrication costs increase.

### SUMMARY OF THE INVENTION

An object of the present invention is to provide a lead assembly for semiconductor devices so as to replace conventional lead frames and achieve the same function. The present invention can also increase the utilization ratio of metal material thereby saving material costs.

A further object of the present invention is to provide a lead assembly suitable for automated production. The invention utilizes metal lead material efficiently and uses materials with superior physical properties. In addition, the present invention can be processed easily so as to facilitate mass production thus resulting in lower production costs.

### BRIEF DESCRIPTION OF THE DRAWINGS

The present invention will be fully understood from the detailed description given hereinbelow and the accompanying drawings which are given by way of illustration only, and thus do not limit the present invention, and wherein:
Fig. 1 shows a conventional lead frame for semiconductor devices; and
Fig. 2 shows a lead assembly for semiconductor devices according to the present invention.

### DETAILED DESCRIPTION OF A PREFERRED EMBODIMENT

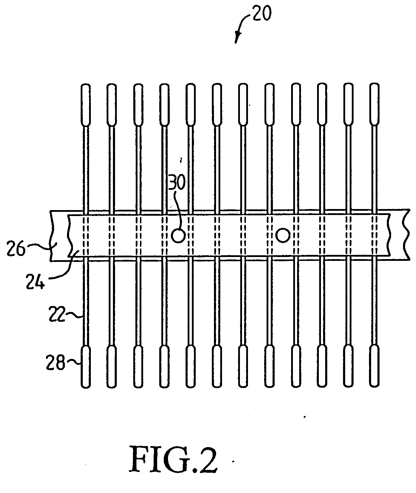

Fig. 2 shows a lead assembly 20 for semiconductor devices according to the invention, which provides the same function as conventional lead frames and achieves the objects of utilizing metal lead material more efficiently and being suitable for automated production. The metal lead 22 utilized in the invention is generally rounded copper wire. The diameter and length of the metal lead 22 is calculated based on the requirements for the product. Those requirements such as current intensity, chip dimension, and heat dissipation are all taken into consideration to determine the dimensions for the lead. The metal leads 22 are cut, flattened at both ends, and fixed on the joining band 26 with a fixing means 24 by automated machines. The metal leads are separated from each other by a predetemined distance. Materials used for the joining band 26 are paper, plastic, and metal, etc. The fixing means 24 can be various adhesive materials and tape materials. In an embodiment of the invention, a durable band like a bristol board is utilized as the joining band 26 and a hot-melt paper tape is utilized as the fixing means 24. Those above materials are preferred in a lead assembly since their cost is low and they have the required mechanical strength and adhesive strength to be easily processed and are suitable for automated production. Alternatively, if a metal band is used as the joining band, the metal leads are fixed on the metal band by a soldering material or a rivet. Furthermore, positioning holes 30 is provided on the joining band 26 of the lead assembly of the invention for accurately transferring and positioning the joining band 26 for automated production. The chip or element which is to be utilized is placed on the flattened end 28 of each metal lead and further packaged to be applied in an electrical circuit. Thus, the lead assembly according to the invention can completely replace the conventional lead frame and achieve the same function. The lead assembly of the invention also achieves the objects of obtaining simpler and more convenient design, saving costs, and being suitable for automated production like that of the conventional lead frame.

While the invention has been described by way of the preferred embodiment, it is to be understood that the invention is not limited to the disclosed embodiment. To the contrary, it is intended to cover various modifications and similar arrangements as would be apparent to those skilled in the art. Therefore, the scope of the appended claims should be accorded the broadest interpretation so as to encompass all such modifications and similar arrangements.

## Claims

1. A lead assembly for semiconductor devices, comprising:
a plurality of metal leads, said metal leads being separated from each other at a predetermined distance and two ends of each of said metal leads being flattened;
a joining band on which said metal leads are placed; and
a fixing means for fixing said metal leads on said joining band.

2. The lead assembly as claimed in Claim 1, wherein said fixing means is an adhesive tape.

3. The lead assembly as claimed in Claim 1, wherein said fixing means is a soldering material.

4. The lead assembly as claimed in Claim 1, wherein said fixing means is a revit.

5. The lead assembly as claimed in Claim 1 or 2, wherein said joining band and said fixing means are provided with positioning holes, and said positioning holes are separated from each other at a predetermined distance in order to facilitate accurately transferring and positioning said lead assembly.

6. A lead assembling method for semiconductor devices, comprising the steps of:
cutting a metal lead of a required diameter into pieces of metal leads of a required length;
flattening the ends of each metal lead;
placing said metal leads on a joining band and separating said metal leads from each other by a predetermined distance; and
fixing each of said metal leads on said joining band with a fixing means.

7. The lead assembling method as claimed in Claim 6, further comprising the step of providing some positioning holes on the fixed joining band and said fixing means and separating said positioning holes by a predetermined distance in order to facilitate accurately transferring and positioning the joining band.
